# EUROPEAN PATENT SPECIFICATION

(11) **EP 2 182 789 B1**
(45) Date of publication and mention of the grant of the patent: **18.09.2013**
(21) Application number: 09174496.1
(22) Date of filing: 29.10.2009
(51) Int. Cl.: H05K 5/02, H05K 7/20

(54) **Heat dissipation window and communication equipment**
Wärmeableitungsfenster und Kommunikationsgerät
Fenêtre de dissipation de chaleur et équipement de communication

(30) Priority: 29.10.2008 CN 200820139660 U; 01.06.2009 WO PCT/CN2009/072060
(43) Date of publication of application: 05.05.2010
(73) Proprietor: HUAWEI DEVICE CO., LTD, Shenzhen, Guangdong 518129 (CN)
(72) Inventor: Zhao, Shuai, 518129, Shenzhen Guangdong (CN)
(74) Representative: Thun, Clemens

(56) References cited:
- EP-A- 2 018 093
- JP-A- 9 304 834
- JP-A- 61 246 532
- US-B1- 6 330 155

## Description

### FIELD OF THE TECHNOLOGY

The present invention relates to a communication technical field, and more particularly to a heat dissipation window and communication equipment.

### BACKGROUND

At present, transmission rate of a wireless data terminal is higher and higher, and power consumption increases accordingly, so temperature of the wireless data terminal rises accordingly, which causes a great number of problems. A temperature rise would lead to decreased performance, shorten lifetime of a device, and more seriously, produce great potential safety hazards.

During process of realizing the invention, the inventor finds that there are at least the following problems in the conventional art:

In the case that volume of a communication equipment becomes smaller and smaller, space for reducing the power consumption and enhancing efficiency is very limited, which is difficult to meet cooling requirement.

JP 09304834A discloses a liquid crystal projector device which includes a bimetal, a coupling tool and fins. One end of the bimetal is fixed to the side part of a box by a supporting part and the coupling tool is fitted to an other end of the bimetal. The end part of the tool is fitted to the other ends of the fins to be freely movable.

EP 2018093A relates to an apparatus and a method for circulation and discloses a airflow recirculation valve which comprises a bi-metallic spring, the bi-metallic spring expands and contracts a predetermined amount and the predetermined amount is based at least in part upon a temperature change.

US 6,330,155 B1 discloses method and apparatus for a temperature control of electrical devices mounted on circuit boards.

### SUMMARY

The embodiment of the present invention provides a heat dissipation window and communication equipment, which drives a window body of the heat dissipation window to open

or close by heat energy generated by the communication equipment to achieve an aim of lowering the temperature of the communication equipment.

To achieve the aim, the embodiment of the present invention provides a heat dissipation window which includes a drive device and a window body, the window body includes an inner window and an outer window, the outer window has a heat dissipation opening, the inner window has shielding body, and a first connector is provided on the inner window.

The drive device is provided with a second connector connected with the first connector on the inner window, the drive device is configured to convert heat energy dissipated from the communication equipment into mechanical energy according to temperature change of a communication equipment, and drive the inner window to move by using the mechanical energy so as to enable the shielding body to shield or expose the heat dissipation opening. The outer window has a sliding slot in which the inner window can slide.

The embodiment of the present invention provides a communication equipment which includes the above heat dissipation window, and the heat dissipation window is located on a shell of the communication equipment.

Compared to the conventional art, the embodiment of the present invention has the following advantages: the drive device of the heat dissipation window provided in the embodiment of the invention can drive the opening and closing of the window body of the heat dissipation window by the heat energy generated by the communication equipment, thus accelerating heat dissipation of the communication equipment and achieving the aim of lowering the temperature of the communication equipment.

### BRIEF DESCRIPTION OF THE DRAWINGS

To clearly describe the technical proposal of the embodiment of the present invention, accompanying drawings which are used in the description of the embodiment are introduced as follows. Obviously, the accompanying drawings described below are only some embodiments of the present invention, and other accompanying drawings can be obtained by those of ordinary skill in the art according to these accompanying drawings without creative labor.
Figure 1 is a structural diagram of the heat dissipation window according to an embodiment of the present invention.
Figure 2 is a functional diagram illustrating that the drive device controls the opening and closing of the window body according to temperature change according to an embodiment of the present invention.
Figure 3 is a schematic diagram of the appearance of the communication equipment with the window body according to an embodiment of the present invention.
Figure 4 is a structural diagram of the communication equipment with the window body in Figure 3 according to an embodiment of the present invention.
Figure 5(a) is a schematic diagram of the outer window after the shutter-type window body is opened according to an embodiment of the present invention.
Figure 5(b) is a schematic diagram of the inner window after the shutter-type window body is opened according to an embodiment of the present invention.
Figure 6(a) is a schematic diagram of the shape of the outer window according to an embodiment of the present invention.
Figure 6(b) is another schematic diagram of the shape according to the outer window according to an embodiment of the present invention.
Figure 6(c) is another schematic diagram of the shape of the outer window according to an embodiment of the present invention.
Figure 6(d) is another schematic diagram of the shape of the outer window according to an embodiment of the present invention.
Figure 6(e) is another schematic diagram of the shape of the outer window according to an embodiment of the present invention.
Figure 7(a) is another schematic diagram of the shape of the outer window according to an embodiment of the present invention.
Figure 7(b) is a further schematic diagram of the shape of the outer window according to an embodiment of the present invention.
Figure 8 is a schematic diagram of the cantilever beam type thermal bimetal dome according to an embodiment of the present invention.
Figure 9 is a schematic diagram of the communication equipment when the window body is closed according to an embodiment of the present invention.
Figure 10 is a schematic diagram of the communication equipment after the thermal bimetal dome deforms according to an embodiment of the present invention.
Figure 11(a) is a schematic diagram of the shape of the outer window with the inner window rotatable according to an embodiment of the present invention.
Figure 11(b) is a further schematic diagram of the shape of the outer window with the inner window rotatable according to an embodiment of the present invention.
Figure 11(c) is a further schematic diagram of the shape of the outer window with the inner window rotatable according to an embodiment of the present invention.
Figure 12 is a schematic diagram of the thermal bimetal dome being designed as a coil dome according to an embodiment of the present invention.
Figure 13(a) is a structural schematic diagram of the outer window of the window body when the thermal bimetal dome is designed as a coil dome according to an embodiment of the present invention.
Figure 13(b) is a structural schematic diagram of the inner window of the window body when the thermal bimetal dome is designed as a coil dome according to an embodiment of the present invention.
Figure 14(a) is a schematic diagram of the opened state of the blades when the window body is designed as a turnover shutter according to an embodiment of the present invention.
Figure 14(b) is a schematic diagram of the closed state of the blades when the window body is designed as a turnover shutter according to an embodiment of the present invention.
Figure 14(c) is a schematic diagram of the shape of the inner window when the window body is designed as a turnover shutter according to an embodiment of the present invention.
Figure 15(a) is a schematic diagram of the opened state of the blades when the window body is provided with ribs according to an embodiment of the present invention.
Figure 15(b) is a schematic diagram of the closed state of the blades when the window body is provided with ribs according to an embodiment of the present invention.
Figure 15(c) is a schematic diagram of the shape of the inner window when the window body is provided with ribs according to an embodiment of the present invention.
Figure 16 is a schematic diagram of the connection of the fixed end of the thermal bimetal dome with the metal shielding cover of a main heating device according to an embodiment of the present invention.
Figure 17 is a further schematic diagram of the connection of the fixed end of the thermal bimetal dome with the metal shielding cover of a main heating device according to an embodiment of the present invention.

### DETAILED DESCRIPTION

Herein, the technical solution of the embodiments of the present invention is clearly and totally described by combining the accompanying drawings of the embodiments of the present invention. Obviously, the described embodiments are not all the embodiments of the present invention but only part of the embodiments. Based on the embodiments of the present invention, the other embodiments which are obtained without creative labor of those skilled in the art belong to the protection scope of the present invention.

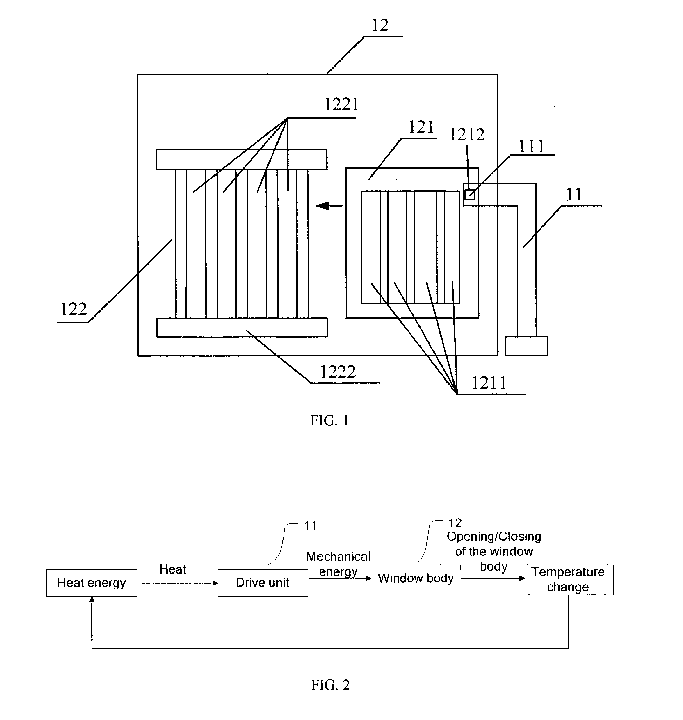

An embodiment of the present invention provides a heat dissipation window which is located on a shell of communication equipment. As shown in Figure 1, the heat dissipation window includes a drive device 11 and a window body 12. The window body 12 includes an inner window 121 and an outer window 122, the outer window 122 has a heat dissipation opening 1221, and the inner window 121 has a shielding body 1211 and a first connector 1212. It should be noted that the heat dissipation window provided in the embodiment of the present invention is applicable to the communication equipment, preferably to wireless communication equipment.

The drive device 11 is provided with a second connector 111 connected with the shielding body 1211 through the first connector 1212 on the inner window 121, the drive device 11 converts the heat energy dissipated from the communication equipment into mechanical energy according to temperature change of the communication equipment, and drives the shielding body 1211 to move by using the mechanical energy so as to enable the shielding body 1211 to shield or expose the heat dissipation opening 1221 of the outer window 122.

The outer window 122 may have a sliding slot 1222 in which the inner window 121 may slide.

When the first connector 1212 is a hole, the second connector 111 is a protrusion or a cylinder; and when the first connector 1212 is a protrusion or a cylinder, the second connector 111 is a hole.

In the embodiments of the present invention, the drive device 11 converts the heat energy into the mechanical energy which drives the opening and closing of the window body 12, the opening and closing of the window body 12 directly affects the temperature in the communication equipment, and the temperature change affects the heat energy. The embodiment of the present invention realizes that the drive device 11 automatically controls the opening and closing of the window body 12 according to the temperature change of the communication equipment, which keeps the temperature in the communication equipment constant.

Figure 2 is a functional diagram illustrating that the drive device 11 controls the opening and closing of the window body 12 according to temperature change according to an embodiment of the present invention. The temperature rises as the communication equipment works, and the heat energy increases continuously, which causes continuous increase of the mechanical energy converted by the drive device 11 so that the opening size of the opened heat dissipation opening of the window body 12 increases continuously. The increase of the size of the heat dissipation opening accelerates the heat dissipation, lowers the temperature, reduces the heat energy, reduces the converted mechanical energy, and reduces the opening size of the heat dissipation opening. Thus, a dynamic balance is realized to keep the temperature at a set temperature. Furthermore, in the embodiments of the present invention, the conversion from the heat energy to the mechanical energy may lower the temperature of the communication equipment.

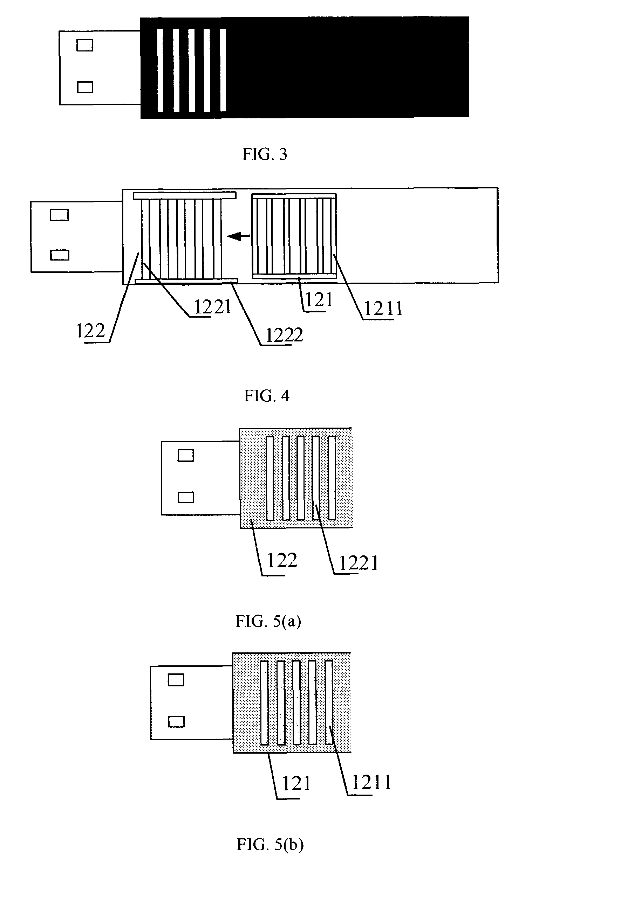

To realize the opening and closing of the window body 12 and meet the strength requirement of the communication equipment, the appearance of the window body 12 of the communication equipment may be as shown in Figure 3, and the structure thereof is as shown in Figure 4. The window body as shown in Figure 3 includes the inner window 121 and the outer window 122, the heat dissipation opening 1221 of the outer window 122 specifically may be a plurality of vertical strip holes, the inner window 121 has a plurality of vertical strip shielding body, and the plurality of vertical strip shielding bodies 1211 of the inner window 121 may be directly towards the vertical strip holes of the outer window 122 under the drive of the drive device 11. The inner window 121 has a hole, the drive device 11 has a protrusion, the drive device 11 is connected with the inner window 121 through the protrusion and the hole on the inner window 121, the drive device 11 converts the heat energy dissipated from the communication equipment into the mechanical energy according to the temperature change of the communication equipment, and the mechanical energy drives the inner window 121 to slide in the sliding slot 1222 of the outer window 122, to enable the shielding body 1211 of the inner window 121 to shield or expose the heat dissipation opening 1221 of the outer window 122 so as to achieve the aim of opening and closing the window body 12.

When the heat dissipation opening 1221 of the outer window 122 is vertical strip holes and the window body 12 is closed, the plurality of shielding bodies 1211 of the inner window 121 may be directly towards the heat dissipation opening 1221 of the outer window 122 under the drive of the drive device to totally shield each of openings of a shutter, the heat dissipation opening 1221 of the outer window 122 may be shielded or exposed by slightly moving the inner window 121. The moving distance of the inner window 121 decides the opening or closing size of the heat dissipation opening 1221 of the outer window 122. Please continue to refer to Figures 5(a)-(b) which are schematic diagrams after the window body 12 is opened.

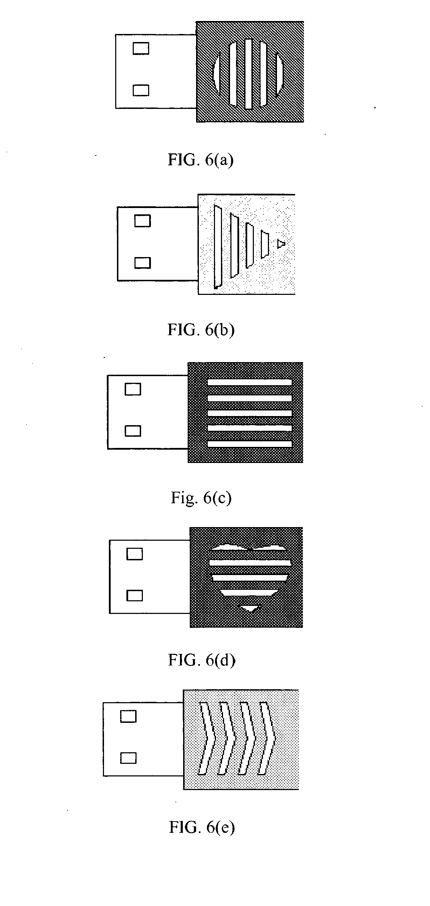

Additionally, the heat dissipation opening of the outer window 122 may be flexibly designed according to the requirements of structure and identification. As shown in Figures 6(a)-(e), the heat dissipation opening 1221 of the outer window 122 may also be a plurality of horizontal strip holes, and the inner window 121 has a plurality of horizontal strip shielding bodies. When the inner window body 12 is closed, the plurality of shielding bodies of the inner window 121 is directly towards the horizontal strip holes of the outer window 122. The shape of the heat dissipation opening of the outer window may be round, triangular, peach-heart-shaped or shark-gill-shaped.

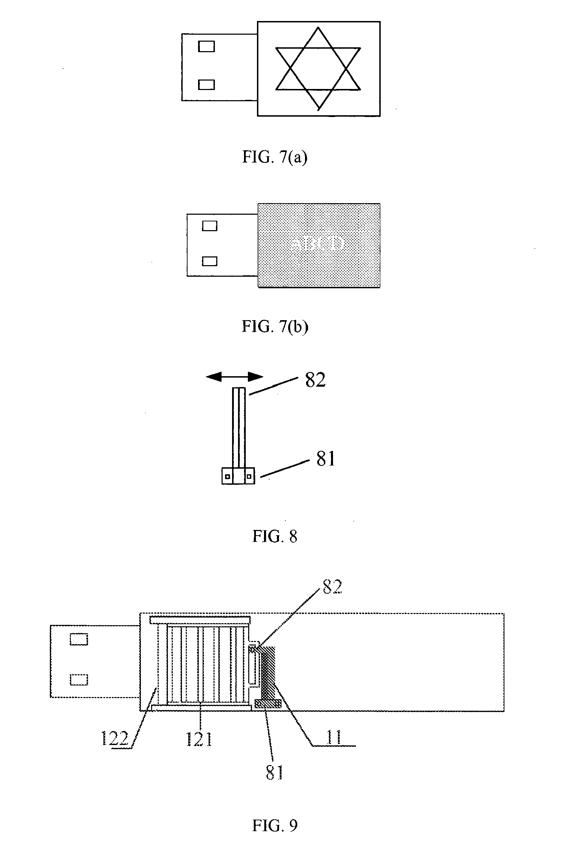

As shown in Figures 7(a)-(b), the heat dissipation opening 1221 of the outer window 122 may be designed as LOGO (a sign of logogram) and even a character, and the shielding body of the inner window 121 is a shielding sheet.

In the embodiments of the present invention, the drive device 11 may be made of a thermal bimetal dome which is one of precision alloy and is formed by firmly binding two (or more) layers of metals or alloys which are acted as constituent layers and have different thermal expansion coefficients. However, the embodiment of the present invention is not limited to this. The drive device 11 may also be made of other temperature sensing materials, which does not affect the realization of the embodiments of the present invention.

In the embodiments of the present invention, the thermal bimetal dome of the drive device 11 may be designed as a cantilever beam type structure. As shown in Figure 8, one end of the thermal bimetal dome is fixed on the shell of the communication equipment as a fixed end 81, and the other end is hung as a mobile end 82 which is connected with the shielding body 1211 of the inner window 121. When the temperature changes, the mobile end 82 may swing back and forth to drive the shielding body 1211 of the inner window 121 to move.

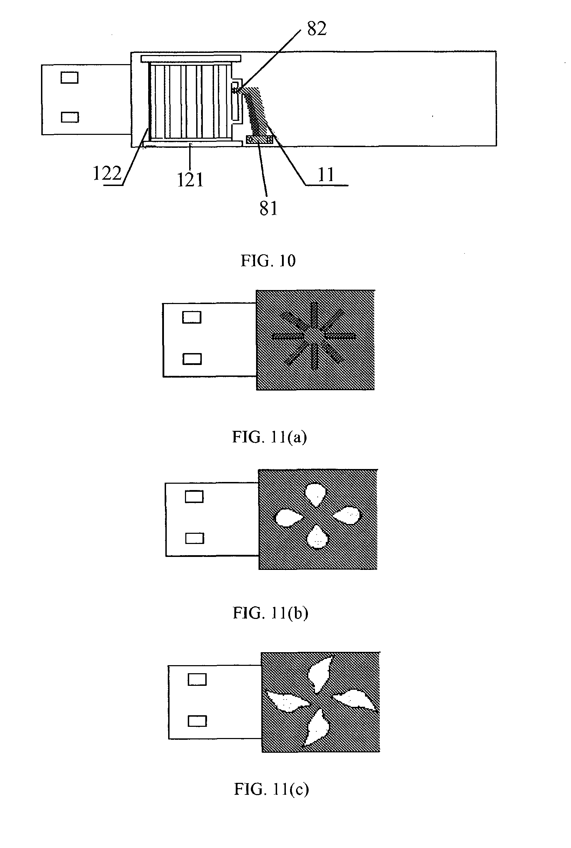

When the window body 12 is closed, the position of the thermal bimetal dome of the drive device 11 is as shown in Figure 9. When the temperature rises, the thermal bimetal dome deforms, the heat dissipation opening is opened, and the position of the thermal bimetal dome is as shown in Figure 10.

The thermal bimetal dome of the drive device 11 may also be designed as a coil spring. When the temperature changes, the thermal bimetal dome is subject to rotational deformation to drive the inner window 121 to rotate, in which case the shape of the heat dissipation opening 1221 of the outer window 122 is as shown in Figures 11(a)-(c).

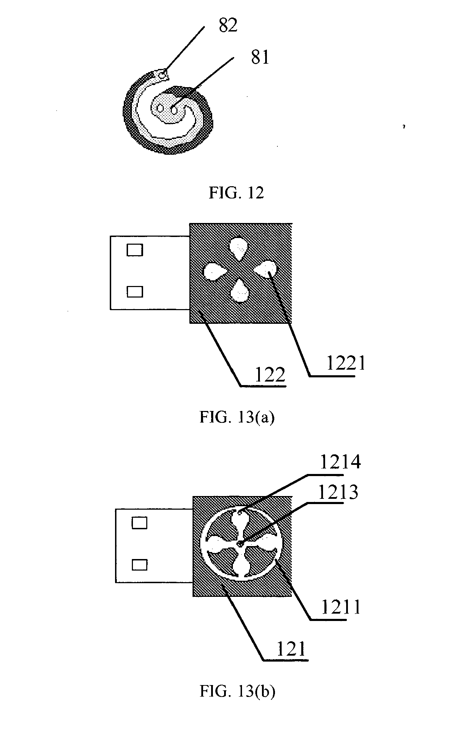

The thermal bimetal dome of the drive device 11 may also be designed as a coil dome. As shown in Figure 12, a circle center end is a fixed end 81 which is fixed on the shell of the communication equipment, and tan outer circle end is a mobile end 82 which is connected with the shielding body 1211 of the inner window 121. When the temperature changes, the thermal bimetal dome is rotated by using different deformations of the thermal bimetal dome so as to drive the shielding body 1211 of the inner window 121 to rotate.

At this time, as shown in Figures 13(a)-(b), the shielding body 1211 of the inner window 121 of the window body 12 consists of a circular wheel disk which is fixed on the outer window 122 at its circle center and freely rotates with the fixed point as a center. The mobile end 82 of the thermal bimetal dome is connected with a mobile shaft of the circular wheel disk, and the fixed end 81 is fixed on a single plate opposite to a circle center shaft 1213. The thermal bimetal dome deforms under the drive of the temperature, and the mobile end 82 drives the circular wheel disk to rotate so as to achieve the aim of shielding and exposing the heat dissipation opening 1221 of the outer window 122.

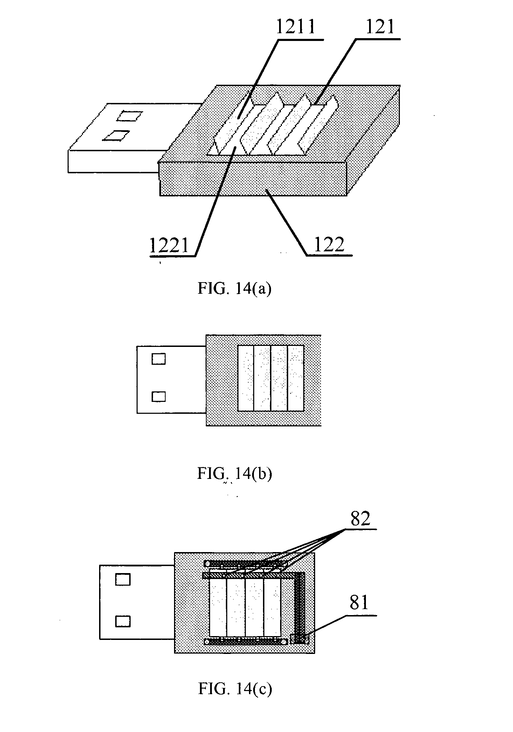

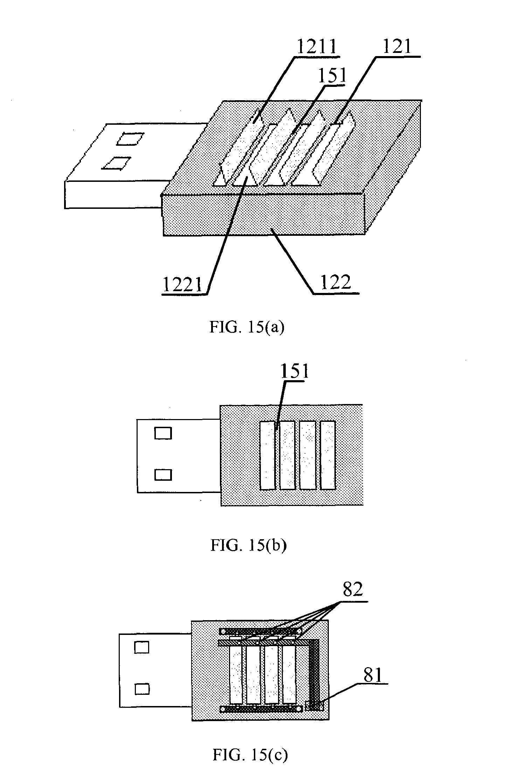

Figures 14(a)-(c) and 15(a)-(c) describe a known method using shutters.

As shown in Figures 14(a)-(b), the heat dissipation opening 1221 of the outer window 122 may also be a rectangular hole in which the inner window 121 may be embedded, and the shielding body 1211 of the inner window 121 may be a turnover shutter. When the blades of the shutter are closed, the heat dissipation opening 1221 of the outer window 122 is totally shielded.

As shown in Figure 14(c), the fixed end 81 of the thermal bimetal dome may be fixed on the single plate, the mobile end 82 of the thermal bimetal dome is connected with the blades of the shutter, and the thermal bimetal dome may be the cantilever beam type structure as shown in Figure 8. The thermal bimetal dome deforms under the drive of the temperature so as to drive the blades of the shutter to rotate with a certain angle so that the heat dissipation opening 1221 of the outer window 122 is opened with a corresponding size.

Ribs 151 may be arranged between the blades of the shutter, and lie across the rectangular hole of the outer window 122 to form the shielding body 1211 of the inner window 121 together with the blades. As shown in Figures 15(a)-(b), the left figure shows the open state of the blades of the shutter, and the right figure shows the closed state of the blades of the shutter. When the blades of the shutter are closed, the heat dissipation opening 1221 of the outer window 122 is totally shielded.

At this time, as shown in Figure 15(c), the fixed end 81 of the thermal bimetal dome may be fixed on the single plate, and the mobile end 82 of the thermal bimetal dome is connected with the blades of the shutter. The thermal bimetal dome may be the cantilever beam type structure as shown in Figure 8. The thermal bimetal dome deforms under the drive of the temperature change to drive the blades of the shutter to rotate with a certain angle so that the heat dissipation opening 1221 of the outer window 122 is opened with a corresponding size.

The drive device 11 is driven by the heat energy, so no extra electric energy supply is needed, but the heat energy generated by the equipment itself is needed to drive the equipment, which realizes secondary utilization of the energy. The equipment has the advantages of environmental protection, safety, no pollution, etc.

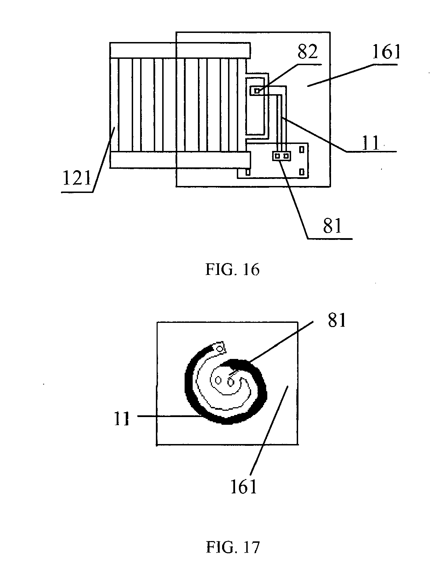

To perfectly utilize the heat energy, the heat energy adjacent to the main heating device of the communication equipment is transferred to the drive device 11 by a metal, that is, the thermal bimetal dome. Taking the communication equipment as an example, as shown in Figure 16 and Figure 17, the fixed end 81 of the thermal bimetal dome is connected with a metal shielding cover 161 of the main heating device, which realizes to fix the thermal bimetal dome, enhances the energy transferring speed, accelerates the response of the communication equipment, and preferably dissipates heat.

The heat dissipation window provided in the embodiment of the present invention has the advantages of environmental protection, no energy consumption, no radiation, no noise and no pollution, and the window body of the heat dissipation window is driven to be opened or closed by using the heat energy generated by the communication equipment, which accelerates the heat dissipation of the communication equipment and achieves the aim of lowering the temperature of the communication equipment.

Those skilled in the art can understand that the accompanying drawings are only the schematic diagrams of a preferred embodiment, and the modules shown in the accompanying drawings are not always necessary for implementing the present invention.

Those skilled in the art can understand that the modules of the device in the embodiment can be distributed in the device of the embodiment according to the description of the embodiment, and can also be arranged in one or more devices different from the embodiment according to corresponding changes. The modules of the embodiments can be combined into one module, and can also be further divided into a plurality of submodules.

The disclosure describes only some specific embodiments of the present invention, but the invention is not limited to these embodiments, and the changes which can be thought of by those skilled in the art should fall into the protection scope of the invention.

## Claims

1. A heat dissipation window comprising a drive device (11) and a window body (12), the window body (12) comprising an inner window (121) having a shielding body (1211) and an outer window (122) having a heat dissipation opening (1221), a first connector (1212) being provided on the inner window (121), and the drive device (11) being provided with a second connector (111) connected with the first connector (1212) on the inner window (121),
**characterized in that**
the drive device (11) is configured to convert heat energy dissipated from a communication equipment into mechanical energy according to temperature change of the communication equipment, and drive the inner window (121) to move by using the mechanical energy so as to enable the shielding body (1211) to shield or expose the heat dissipation opening (1221), and
the outer window (122) has a sliding slot (1222) in which the inner window (121) can slide.

2. The heat dissipation window according to claim 1, wherein when the first connector (1212) is a hole, the second connector (111) is a protrusion; or, when the first connector (1212) is a protrusion, the second connector (111) is a hole.

3. The heat dissipation window according to claim 1, wherein the heat dissipation opening (1221) of the outer window (122) is specifically a plurality of vertical strip holes, the inner window (121) has a plurality of vertical strip shielding bodies (1211), and when the window body (12) of the heat dissipation window is closed, the plurality of shielding bodies (1211) of the inner window (121) are directly towards the vertical strip holes of the outer window (122); or, the heat dissipation opening (1221) of the outer window is specifically a plurality of horizontal strip holes, the inner window (121) has a plurality of horizontal strip shielding bodies, and when the window body (12) of the heat dissipation window is closed, the plurality of horizontal strip shielding bodies of the inner window (121) are directly towards the horizontal strip holes of the outer window (122).

4. The heat dissipation window according to claim 3, wherein a shape of the heat dissipation opening (1221) of the outer window (122) is round, triangular, peach-heart-shaped or shark-gill-shaped.

5. The heat dissipation window according to claim 1, wherein a shape of the heat dissipation opening (1221) of the outer window (122) is a sign LOGO or a character, and the shielding body of the inner window is a shielding sheet.

6. The heat dissipation window according to claim 1, wherein the drive device (11) is made of a thermal bimetal dome.

7. The heat dissipation window according to claim 6, wherein the thermal bimetal dome is a cantilever beam type structure, one end of the thermal bimetal dome is a fixed end which is fixed on a shell of the communication equipment or a main heating device of the communication equipment, and the other end is a hanging mobile end.

8. The heat dissipation window according to claim 6, wherein the thermal bimetal dome is a coil spring or a coil dome, a circle center end of the coil spring or the coil dome is a fixed end (81) which is fixed on a shell of the communication equipment or a main heating device of the communication equipment, and an outer circle end is a mobile end (82).

9. A communication equipment, comprising a heat dissipation window according to any one of claims 1 to 8, wherein the heat dissipation window is located on a shell of the communication equipment.

## Patentansprüche

1. Wärmeableitungsfenster, umfassend eine Antriebseinrichtung (11) und einen Fensterkörper (12), wobei der Fensterkörper (12) ein inneres Fenster (121) mit einem Abschirmungskörper (1211) und ein äußeres Fenster (122) mit einer Wärmeableitungsöffnung (1221) umfasst, wobei ein erstes Verbindungsstück (1212) an dem inneren Fenster (121) vorgesehen ist und die Antriebseinrichtung (11) mit einem zweiten Verbindungsstück (111) ausgestattet ist, das mit dem ersten Verbindungsstück (1212) an dem inneren Fenster (121) verbunden ist,
**dadurch gekennzeichnet, dass**
die Antriebseinrichtung (11) konfiguriert ist zum Umwandeln von von einem Kommunikationsgerät abgeleiteter Wärmeenergie in mechanische Energie gemäß einer Temperaturänderung des Kommunikationsgeräts und zum Antreiben des inneren Fensters (121) zum Bewegen durch Verwenden der mechanischen Energie, damit der Abschirmungskörper (1211) die Wärmeableitungsöffnung (1221) abschirmen oder exponieren kann, und
das äußere Fenster (122) einen Gleitschlitz (1222) aufweist, in dem das innere Fenster (121) gleiten kann.

2. Wärmeableitungsfenster nach Anspruch 1, wobei, wenn das erste Verbindungsstück (1212) ein Loch ist, das zweite Verbindungsstück (111) ein Vorsprung ist; oder wenn das erste Verbindungsstück (1212) ein Vorsprung ist, das zweite Verbindungsstück (111) ein Loch ist.

3. Wärmeableitungsfenster nach Anspruch 1, wobei es sich bei der Wärmeableitungsöffnung (1221) des äußeren Fensters (122) spezifisch um mehrere vertikale streifenförmige Löcher handelt, wobei das innere Fenster (121) mehrere vertikale streifenförmige Abschirmungskörper (1211) aufweist, und wenn der Fensterkörper (12) des Wärmeableitungsfensters geschlossen ist, die mehreren Abschirmungskörper (1211) des inneren Fensters (121) direkt zu den vertikalen streifenförmigen Löchern des äußeren Fensters (122) gewandt sind; oder wenn es sich bei der Wärmeableitungsöffnung (1221) des äußeren Fensters spezifisch um mehrere horizontale streifenförmige Löcher handelt, das innere Fenster (121) mehrere horizontale streifenförmige Abschirmungskörper aufweist, und wenn der Fensterkörper (12) des Wärmeableitungsfensters geschlossen ist, die mehreren horizontalen streifenförmigen Abschirmungskörper des inneren Fensters (121) direkt den horizontalen streifenförmigen Löchern des äußeren Fensters (122) zugewandt sind.

4. Wärmeableitungsfenster nach Anspruch 3, wobei eine Form der Wärmeableitungsöffnung (1221) des äußeren Fensters (122) rund, dreieckig, pfirsichherzförmig oder haikiemenförmig ist.

5. Wärmeableitungsfenster nach Anspruch 1, wobei eine Form der Wärmeableitungsöffnung (1221) des äußeren Fensters (122) ein Symbol LOGO oder ein Zeichen ist und der Abschirmungskörper des inneren Fensters eine Abschirmungsfolie ist.

6. Wärmeableitungsfenster nach Anspruch 1, wobei die Antriebseinrichtung (11) aus einem Wärmebimetalldom besteht.

7. Wärmeableitungsfenster nach Anspruch 6, wobei der Wärmebimetalldom eine Struktur vom Typ freitragender Balken ist, wobei ein Ende des Wärmebimetalldoms ein festes Ende ist, das an einer Schale des Kommunikationsgeräts, oder einer Hauptheizeinrichtung des Kommunikationsgeräts fixiert ist und das andere Ende ein hängendes mobiles Ende ist.

8. Wärmeableitungsfenster nach Anspruch 6, wobei der Wärmebimetalldom eine Spiralfeder oder ein Spiraldom ist, ein Kreismittenende der Spiralfeder oder des Spiraldoms ein festes Ende (81) ist, das an einer Schale des Kommunikationsgeräts oder einer Hauptheizeinrichtung des Kommunikationsgeräts fixiert ist, und ein äußeres Kreisende ein mobiles Ende (82) ist.

9. Kommunikationsgerät, umfassend ein Wärmeableitungsfenster nach einem der Ansprüche 1 bis 8, wobei sich das Wärmableitungsfenster an einer Schale des Kommunikationsgeräts befindet.

## Revendications

1. Fenêtre de dissipation de chaleur comprenant un dispositif de commande (11) et un corps de fenêtre (12), le corps de fenêtre (12) comprenant une fenêtre interne (121) ayant un corps de blindage (1211) et une fenêtre externe (122) ayant une ouverture de dissipation de chaleur (1221), un premier connecteur (1212) étant fourni sur la fenêtre interne (121), et le dispositif de commande (11) étant doté d'un second connecteur (111) connecté au premier connecteur (1212) sur la fenêtre interne (121), **caractérisé en ce que**
le dispositif de commande (11) est configuré pour convertir l'énergie thermique dissipée par un équipement de communication en énergie mécanique en fonction du changement de température de l'équipement de communication, et commander la fenêtre interne (121) pour qu'elle se déplace en utilisant l'énergie mécanique de façon à permettre au corps de blindage (1211) de blinder ou d'exposer l'ouverture de dissipation de chaleur (1211), et
la fenêtre externe (122) a une fente coulissante (1222) dans laquelle la fenêtre interne (121) peut coulisser.

2. Fenêtre de dissipation de chaleur selon la revendication 1, dans laquelle quand le premier connecteur (1212) est un orifice, le second connecteur (111) est une protubérance, ou, quand le premier connecteur (1212) est une protubérance, le second connecteur (111) est un orifice.

3. Fenêtre de dissipation de chaleur selon la revendication 1 dans laquelle l'ouverture de dissipation de chaleur (1221) de la fenêtre externe (122) est spécifiquement une pluralité d'orifices en bandes verticales, la fenêtre interne (121) a une pluralité de corps de blindage en bandes verticales (1211), et quand le corps de fenêtre (12) de la fenêtre de dissipation de chaleur est fermé, la pluralité de corps de blindage (1211) de la fenêtre interne (121) est dirigée directement vers les orifices en bandes verticales de la fenêtre externe (122) ; ou bien l'ouverture de dissipation de chaleur (1221) de la fenêtre externe est spécifiquement une pluralité d'orifices en bandes horizontales, la fenêtre interne (121) a une pluralité de corps de blindage en bandes horizontales, et quand le corps de fenêtre (12) de la fenêtre de dissipation de chaleur est fermé, la pluralité de corps de blindage en bandes horizontales de la fenêtre interne (121) est dirigée directement vers les orifices en bandes horizontales de la fenêtre externe (122).

4. Fenêtre de dissipation de chaleur selon la revendication 3, dans laquelle une forme de l'ouverture de dissipation de chaleur (1221) de la fenêtre externe (122) est ronde, triangulaire, en forme de coeur ou en forme de branchies de requin.

5. Fenêtre de dissipation de chaleur selon la revendication 1, dans laquelle une forme de l'ouverture de dissipation de chaleur (1221) de la fenêtre externe (122) est un signe de LOGO ou un caractère, et le corps de blindage de la fenêtre interne est une feuille de blindage.

6. Fenêtre de dissipation de chaleur selon la revendication 1, dans laquelle le dispositif de commande (11) est composé d'un dôme bimétallique thermique.

7. Fenêtre de dissipation de chaleur selon la revendication 6, dans laquelle le dôme bimétallique thermique est une structure du type flèche en porte-à-faux, une extrémité du dôme bimétallique thermique est une extrémité fixe qui est fixée à une coque de l'équipement de communication ou à un dispositif de chauffage principal de l'équipement de communication, et l'autre extrémité est une extrémité mobile suspendue.

8. Fenêtre de dissipation de chaleur selon la revendication 6, dans laquelle le dôme bimétallique thermique est un ressort à boudin ou un dôme à boudin, une extrémité centrale circulaire du ressort à boudin ou du dôme à boudin est une extrémité fixe (81) qui est fixée à une coque de l'équipement de communication ou à un dispositif de chauffage principal de l'équipement de communication, et une extrémité circulaire externe est une extrémité mobile (82).

9. Equipement de communication, comprenant une fenêtre de dissipation de chaleur selon l'une quelconque des revendications 1 à 8, la fenêtre de dissipation de chaleur étant située sur une coque de l'équipement de communication.
